# EUROPEAN PATENT APPLICATION

(11) **EP 4 827 261 A1**
(43) Date of publication of application: **21.10.2026**
(21) Application number: 26161006.7
(22) Date of filing: 26.02.2026
(51) Int. Cl.: H10B 12/00

(54) **SEMICONDUCTOR DEVICE WITH STORAGE NODE CONTACTS**

(30) Priority: 14.04.2025 KR 20250047848
(71) Applicant: Samsung Electronics Co., Ltd., Suwon-si, Gyeonggi-do 16677 (KR)
(72) Inventor: PARK, Junhee, 16677 Suwon-si (KR); PARK, Kijeong, 16677 Suwon-si (KR); SHIN, Dain, 16677 Suwon-si (KR); LEE, Dongwon, 16677 Suwon-si (KR); JUNG, Seungjae, 16677 Suwon-si (KR); CHOI, Soyoung, 16677 Suwon-si (KR)
(74) Representative: Marks & Clerk LLP

(57) **Abstract**

A semiconductor device includes: a bit line on a substrate and extending in a first direction parallel to an upper surface of the substrate; a semiconductor pattern on the bit line and extending in a direction perpendicular to the upper surface of the substrate; a gate electrode on a side surface of the semiconductor pattern and extending in a second direction intersecting the first direction; a storage node contact on an upper surface of the semiconductor pattern; an upper insulating layer covering a side surface of the storage node contact; and a capping pattern between the upper insulating layer and the gate electrode. The upper insulating layer is on an upper surface of the capping pattern. The upper surface of the semiconductor pattern and the upper surface the capping pattern each have a concave profile.

## Description

### TECHNICAL FIELD

The implementations of disclosures relate to semiconductors, and more specifically, to a semiconductor device and a method for manufacturing the same.

### BACKGROUND

Semiconductor devices are important in the electronics industry due to their characteristics such as miniaturization, multi-functionalization, and/or low manufacturing cost. The semiconductor devices may include semiconductor memory devices that store logic data, semiconductor logic devices that process logic data, hybrid semiconductor devices that include both a memory element and a logic element, and the like.

With the increase in speed and the decrease in power consumption of electronic devices, the semiconductor devices used in the electronic devices are desired to have a high operating speed and/or a low operating voltage. In order to satisfy these characteristics, a more highly-integrated semiconductor device is needed.

### SUMMARY

A semiconductor device according to some implementations of the disclosure may include: a bit line on a substrate and extending in a first direction parallel to an upper surface of the substrate; a semiconductor pattern on the bit line and extending in a direction perpendicular to the upper surface of the substrate; a gate electrode on a side surface of the semiconductor pattern and extending in a second direction intersecting the first direction; a storage node contact on an upper surface of the semiconductor pattern; an upper insulating layer covering a side surface of the storage node contact; and a capping pattern between the upper insulating layer and the gate electrode, wherein the upper insulating layer is on an upper surface of the capping pattern, and the upper surface of the semiconductor pattern and the upper surface of the capping pattern may each have a concave profile.

A semiconductor device according to some implementations of the disclosure may include: a bit line on a substrate and extending in a first direction parallel to an upper surface of the substrate; a semiconductor pattern on the bit line and extending in a direction perpendicular to the upper surface of the substrate; a gate electrode on a side surface of the semiconductor pattern and extending in a second direction intersecting the first direction; a storage node contact on a upper surface of the semiconductor pattern; an upper insulating layer covering a side surface of the storage node contact; and a capping pattern between the upper insulating layer and the gate electrode, wherein the upper insulating layer is on an upper surface of the capping pattern, the storage node contact includes a first region and a second region between the first region and the semiconductor pattern, the upper surface of the capping pattern may have a concave profile, and a lower surface of the second region of the storage node contact may have a convex profile.

A semiconductor device according some implementations of the disclosure may comprise: a bit line on a substrate and extending in a first direction parallel to an upper surface of the substrate; a semiconductor pattern on the bit line and extending in a direction perpendicular to the upper surface of the substrate; a gate electrode on a side surface of the semiconductor pattern and extending in a second direction intersecting the first direction; a back gate electrode spaced apart from the gate electrode in the first direction and extending in the second direction with the semiconductor pattern interposed therebetween; a storage node contact on an upper surface of the semiconductor pattern; a landing pad on the storage node contact; a data storage pattern on the landing pad; an upper insulating layer covering a side surface of the storage node contact; and a capping pattern between the upper insulating layer and the gate electrode, wherein the upper insulating layer is on an upper surface of the capping pattern, and the upper surface of the semiconductor pattern and the upper surface of the capping pattern may each have a concave profile.

At least some of the above and other features of the invention are set out in the claims.

### BRIEF DESCRIPTION OF THE DRAWINGS

FIG. 1 is a block diagram illustrating a semiconductor device according to some implementations of the disclosure.
FIGS. 2 and 3 are perspective views schematically illustrating a semiconductor device according to some implementations of the disclosure.
FIG. 4 is a plan view illustrating a semiconductor device according to some implementations of the disclosure.
FIG. 5 is a cross-sectional view corresponding to line A-A' of FIG. 4.
FIGS. 6 and 7 are enlarged views corresponding to P1 in FIG. 5.
FIG. 8 is a cross-sectional view corresponding to line A-A' of FIG. 4.
FIG. 9 is an enlarged view corresponding to P2 in FIG. 8.
FIG. 10 is a plan view illustrating a semiconductor device according to some implementations of the disclosure.
FIGS. 11 to 17 are diagrams illustrating a method of manufacturing a semiconductor device according to some implementations of the disclosure.
FIG. 18 is a diagram illustrating a method of manufacturing a semiconductor device according to some implementations of the disclosure.

### DETAILED DESCRIPTION

The implementations of disclosure provide a semiconductor device with improved productivity and a method for manufacturing the same.

Example implementations of the disclosures will now be described more fully with reference to the accompanying drawings, in which example implementations are shown.

With regard to the description of the drawings, similar reference numerals may be used to refer to similar or related elements. As used herein, each of such phrases as "A or B", "at least one of A and B", "at least one of A or B", "A, B, or C", "at least one of A, B, and C", and "at least one of A, B, or C", may include any one of possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order).

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

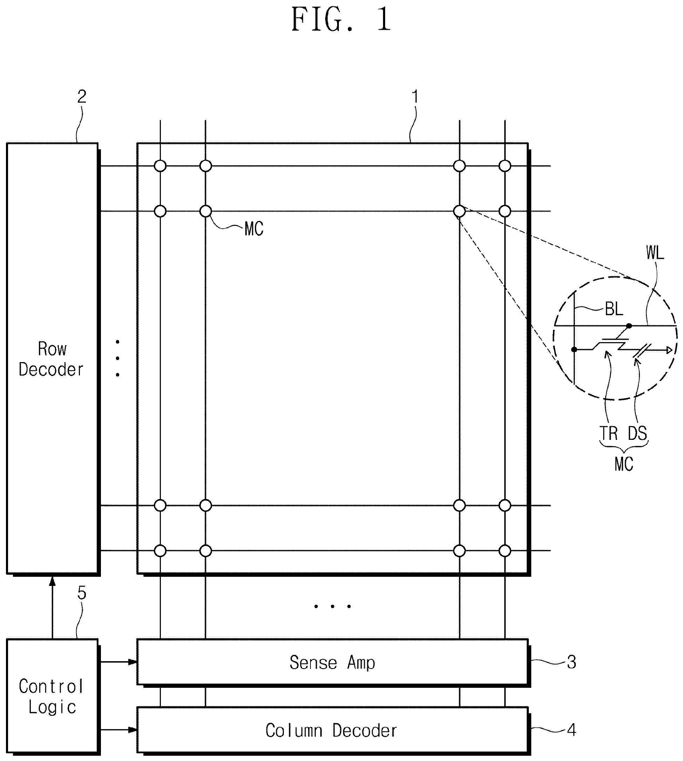

FIG. 1 is a block diagram illustrating a semiconductor device according to some implementations of the disclosure. The semiconductor device may be a memory device. For instance, the semiconductor device may be a random access memory (RAM) device, such as a dynamic RAM (DRAM) device. Having said this, the disclosure is not limited to RAM devices and may relate to any form of memory device.

Referring to FIG. 1, a semiconductor device may include a memory cell array 1, a row decoder 2, a sense amplifier 3, a column decoder 4, and a control logic 5.

The memory cell array 1 may include a plurality of memory cells MC arranged two-dimensionally or three-dimensionally. Each of the memory cells MC may be provided between and connected to a word line WL and a bit line BL, which are provided to cross each other. Each of the memory cells MC may include a selection element TR and a data storage element DS. The selection element TR and the data storage element DS may be electrically connected to each other. The selection element TR may be connected to both the word line WL and the bit line BL. In other words, the selection element TR may be provided at a point where the word line WL and the bit line BL intersect with each other.

The selection element TR may include a field-effect transistor. The data storage element DS may include a capacitor, a magnetic tunnel junction pattern, or a variable resistor. For example, a gate terminal of the transistor that is the selection element TR may be connected to the word line WL, and a source/drain terminals of the transistor may be connected to the bit line BL and the data storage element DS, respectively.

The row decoder 2 may decode an externally input address and select any one of the word lines WL of the memory cell array 1. The address decoded in the row decoder 2 may be provided to a row driver, and the row driver may provide a predetermined voltage to the selected word line WL and the unselected word lines WL, respectively, in response to control of the control circuits.

The sense amplifier 3 may sense, amplify, and output a voltage difference between the selected bit line BL and the reference bit line according to the address decoded from the column decoder 4.

The column decoder 4 may provide a data transfer path between the sense amplifier 3 and an external element (e.g., a memory controller). The column decoder 4 may decode an externally input address to select any one of the bit lines BL. The control logic 5 may generate a control signal that controls an operation of writing or reading data to or from the memory cell array 1.

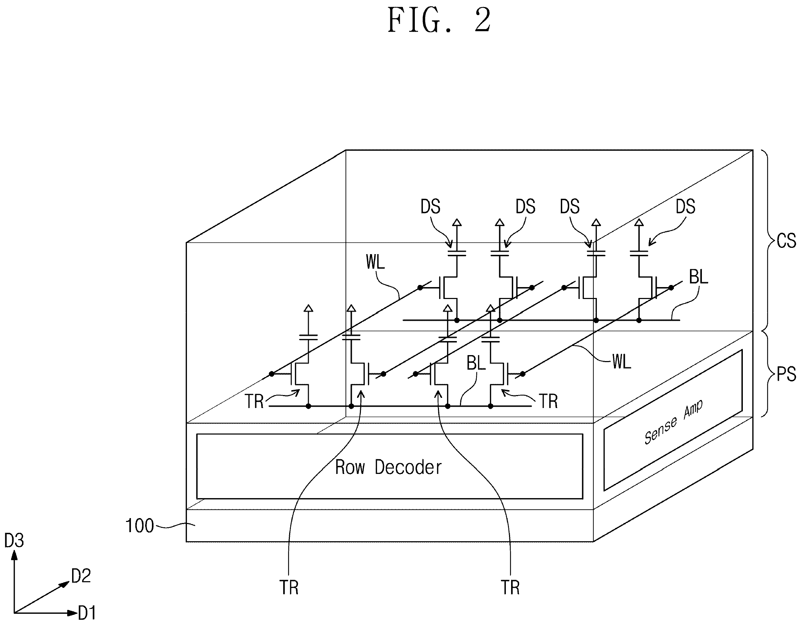

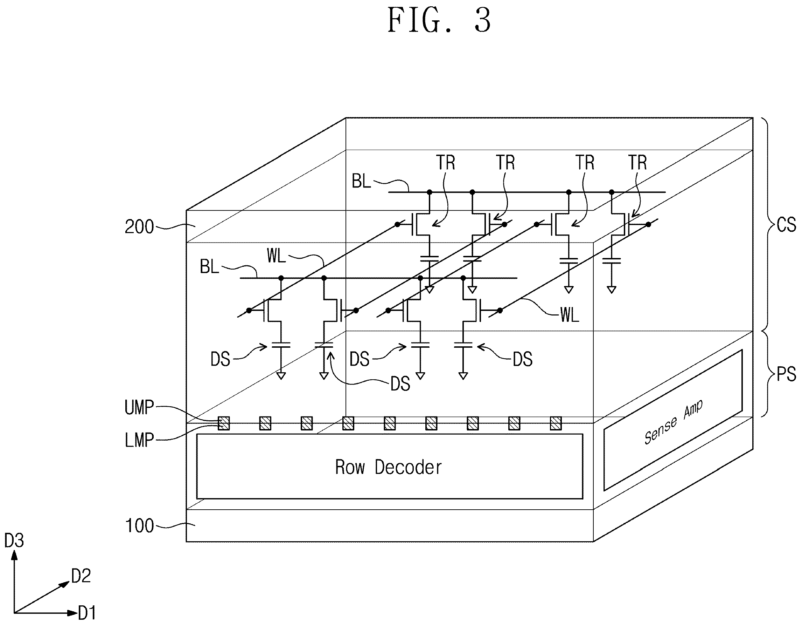

FIGS. 2 and 3 are perspective views schematically illustrating a semiconductor device according to some implementations of the disclosure.

Referring to FIGS. 2 and 3, the semiconductor device may include a peripheral circuit structure PS and a cell array structure CS connected to the peripheral circuit structure PS on the substrate 100. The substrate 100 may have a plate shape extending along a plane defined by a first direction D1 and a second direction D2. The first direction D1 and the second direction D2 are respectively parallel to the upper surface of the substrate 100 and may intersect with (e.g., may be perpendicular to) each other. A third direction D3 may be perpendicular to the upper surface of the substrate 100 and may intersect the first direction D1 and the second direction D2. The third direction D3 may define a vertical direction (e.g., a height direction). The terms "upper", "middle", "lower" may refer to relative positions along the third direction D3. A feature that is defined as "above" another feature may be located further along the third direction D3 than the other feature. It will be appreciated that the positions and directions defined herein are defined relative to the structure of the semiconductor device, and need not limit the semiconductor device to any particular orientation in use.

The peripheral circuit structure PS may include core and peripheral circuits formed on the substrate 100. The core and peripheral circuits may include the row and column decoders 2, 4, the sense amplifier 3, and the control logic 5 described with reference to FIG. 1.

The cell array structure CS may include a memory cell array 1 of FIG. 1 that includes two-dimensionally or three-dimensionally arranged the memory cells MC of FIG. 1. As an example, the selection element TR of FIG. 1 of each of the memory cells MC of FIG. 1 may include a vertical channel transistor. The vertical channel transistor may include a channel whose lengthwise direction is the third direction D3.

Referring to FIG. 2, the peripheral circuit structure PS may be provided on the substrate 100. The cell array structure CS may be provided on the peripheral circuit structure PS. The peripheral circuit structure PS may be connected to the cell array structure CS through additional contacts.

Referring to FIG. 3, the semiconductor device may have a chip-to-chip (C2C) structure. The peripheral circuit structure PS may be provided on the substrate 100. First metal pads LMP may be provided on an upper portion of the peripheral circuit structure PS. The first metal pads LMP may be electrically connected to the core and peripheral circuits. The first metal pads LMP in the peripheral circuit structure PS may be bonded to second metal pads UMP of the cell array structure CS to be described later. Accordingly, the peripheral circuit structure PS and the cell array structure CS may be bonded.

The cell array structure CS may be provided on a carrier substrate 200. The first direction D1 and the second direction D2 may be respectively parallel to the upper surface of the carrier substrate 200. The third direction D3 may be perpendicular to the upper surface of the carrier substrate 200. The second metal pads UMP may be provided in a lower portion of the cell array structure CS. The second metal pads UMP may be electrically connected to the memory cell array 1 of FIG. 1.

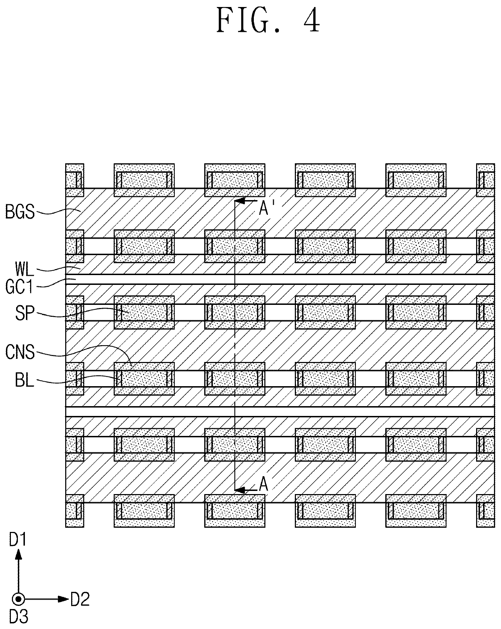

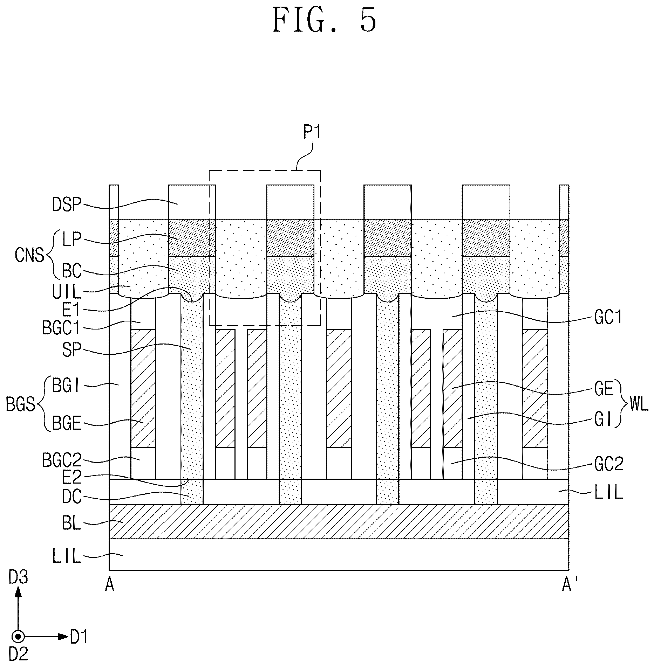

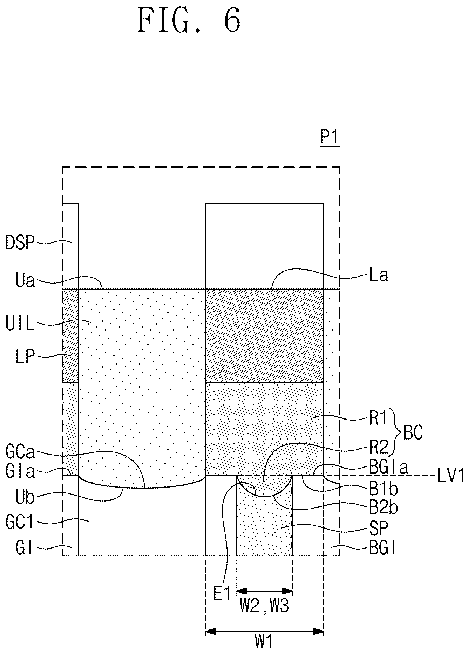

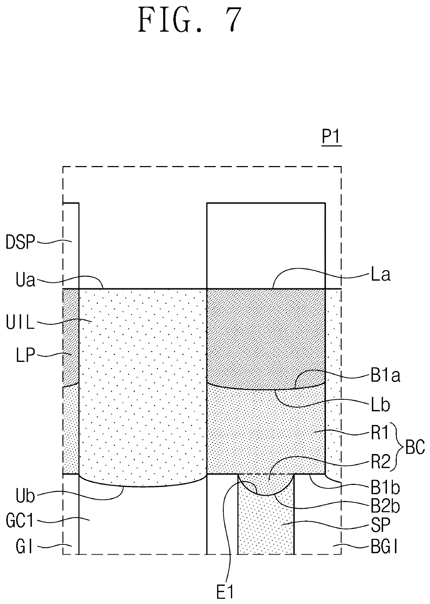

FIG. 4 is a plan view of a semiconductor device according to some implementations of the disclosure. FIG. 5 is a cross-sectional view corresponding to line A-A' of FIG. 4. FIGS. 6 and 7 are enlarged views corresponding to P1 in FIG. 5.

FIGS. 4 and 5 are plan and cross-sectional views, respectively, which illustrate elements in the cell array structure CS described with reference to FIGS. 2 and 3.

The semiconductor device may include a lower insulating layer LIL. The lower insulating layer LIL may include an insulating material. As an example, the lower insulating layer LIL may be provided in a lower portion of the cell array structure CS described with reference to FIG. 2. In this case, the lower insulating layer LIL may be adjacent to and in contact with the peripheral circuit structure PS described with reference to FIG. 2. The peripheral circuit structure PS described with reference to FIG. 2 may be interposed between the substrate 100 described with reference to FIGS. 2A and 2B and the lower insulating layer LIL. The lower insulating layer LIL may include interconnection lines connected to the core and peripheral circuits of the peripheral circuit structure PS described with reference to FIG. 2.

As another example, the cell array structure CS (e.g., see FIG. 2) of the semiconductor device is flipped, so that the lower insulating layer LIL may be provided in an upper portion of the cell array structure CS described with reference to FIG. 3. In this case, the lower insulating layer LIL may be adjacent to and in contact with the carrier substrate 200 described with reference to FIG. 3. In the drawings, a plan view and a cross-sectional view of the cell array structure CS (e.g., see FIG. 2) of the semiconductor device in a non-inverted state are shown, but the disclosure is not limited thereto.

The bit line BL may be provided in the lower insulating layer LIL. The bit line BL in the lower insulating layer LIL may extend in the first direction D1. The bit line BL may include a conductive material. As an example, the bit line BL may include at least one of doped semiconductor materials (e.g., doped silicon, doped germanium, or the like), metallic materials (e. g., Titanium (Ti), Molybdenum (Mo), Tungsten (W), Copper (Cu), Aluminum (Al), Tantalum (Ta), Ruthenium (Ru), Iridium (Ir), Cobalt (Co), or the like) metal silicide materials (e. g, silicides of Ti, Mo, W, Cu, Al, Ta, Ru, Ir, Co, etc.) or metal nitride materials (e.g., nitrides of Ti, Mo, W, Cu, Al, Ta, Ru, Ir, Co, etc.). The bit line BL may be a single layer or a composite layer. A plurality of bit lines BL may be provided. The bit lines BL may be disposed to be spaced apart from each other in the second direction D2. As used herein, "extending" includes "being elongated" or "being oriented along." For example, "extending in the first direction D1" includes "being elongated in the first direction D1" or "being oriented along the first direction D1."

A bit line contact DC may be provided in the lower insulating layer LIL. The bit line contact DC may be provided on the bit line BL. The bit line contact DC may be interposed between a lower surface E2 of a semiconductor pattern SP to be described later and the bit line BL. Accordingly, the bit line BL may be connected to the semiconductor pattern SP through the bit line contact DC. The bit line contact DC may include a conductive material. In an implementation, the bit line contact DC may include doped silicon. A plurality of bit line contacts DC may be provided. A plurality of bit line contacts DC on the bit line BL may be disposed to be spaced apart from each other in the first direction D1.

The semiconductor pattern SP may be provided on the bit line BL. In an implementation, the semiconductor pattern SP may be provided on an upper surface of the bit line contact DC. The semiconductor pattern SP on the bit line BL may extend in the third direction D3. A plurality of semiconductor patterns SP may be provided. The semiconductor patterns SP on one bit line BL may be disposed to be spaced apart from each other in the first direction D1. The semiconductor patterns SP may be disposed to be spaced apart from each other in the second direction D2.

The semiconductor pattern SP may include a semiconductor material. In an implementation, the semiconductor pattern SP may include at least one of silicon (e.g., single crystal silicon), germanium, or silicon-germanium. In an implementation, the semiconductor pattern SP may include an oxide semiconductor. In this case, the oxide semiconductor may include, but is not limited to, at least one of Indium Gallium Zinc Oxide (InGaZnO), Indium Gallium Silicon Oxide (InGaSiO), Indium Tin Zinc Oxide (InSnZnO), Indium Zinc Oxide (InZnO), Zinc Oxide (ZnO), Zinc Tin Oxide (ZnSnO), Zinc Oxynitride (ZnON), Zirconium Zinc Tin Oxide (ZrZnSnO), Tin(II) Oxide (SnO), Hafnium Indium Zinc Oxide (HflnZnO), Gallium Zinc Tin Oxide (GaZnSnO), Aluminum Zinc Tin Oxide (AlZnSnO), Ytterbium Gallium Zinc Oxide (YbGaZnO), or Indium Gallium Oxide (InGaO). In an implementation, the semiconductor pattern SP may include Indium Gallium Zinc Oxide (IGZO). In an implementation, the semiconductor pattern SP may include a two-dimensional semiconductor material. In this case, the two-dimensional semiconductor material may include graphene, carbon nanotubes, or a combination thereof.

A word line WL may be provided on a side surface of the semiconductor pattern SP. The word line WL may be interposed between the semiconductor patterns SP adjacent to each other in the first direction D1. The word line WL may extend in the second direction D2. A plurality of word lines WL may be provided. The word lines WL may be disposed to be spaced apart from each other in the first direction D1. In an implementation, a pair of word lines WL adjacent to each other in the first direction D1 may be interposed between the semiconductor patterns SP adjacent to each other in the first direction D1. In an implementation, a pair of word lines WL adjacent to each other in the first direction D1 may be spaced apart from each other with a first gate capping pattern GC1 to be described later interposed therebetween.

The word line WL may include a gate electrode GE extending in the second direction D2 and the third direction D3 and a gate insulating pattern GI between the semiconductor pattern SP and the gate electrode GE. The gate electrode GE may include a conductive material. As an example, the gate electrode GE may include at least one of metallic materials (e.g., Ti, Mo, W, Cu, Al, Ta, Ru, Ir, Co, etc.). In an implementation, the gate insulating pattern GI may include at least one of silicon oxide or a high-k dielectric materials. Herein, the high-k dielectric material is defined as a material having a dielectric constant higher than that of silicon oxide.

A first gate capping pattern GC1 may be provided on an upper surface of the gate electrode GE. The first gate capping pattern GC1 may be interposed between the gate electrode GE and an upper insulating layer UIL to be described later. A portion of the side surface of the first gate capping pattern GC1 may be covered by the gate insulating pattern GI. The first gate capping pattern GC1 may include an insulating material. In an implementation, the first gate capping pattern GC1 may include silicon oxide.

The first gate capping pattern GC1 may be interposed between the gate electrodes GE adjacent to each other in the first direction D1, and may space them apart. The first gate capping pattern GC1 may extend in the third direction D3. The first gate capping pattern GC1 may include a cutting portion that is positioned between adjacent gate electrodes GE, and a capping portion that is positioned on upper surfaces of the adjacent gate electrodes GE.

A second gate capping pattern GC2 may be interposed between the gate electrode GE and the lower insulating layer LIL. The second gate capping pattern GC2 may include an insulating material. In an implementation, the second gate capping pattern GC2 may include silicon oxide.

A back gate structure BGS may be provided on the side surface of the semiconductor pattern SP. The back gate structure BGS may be interposed between the semiconductor patterns SP adjacent to each other in the first direction D1. The back gate structure BGS and the word line WL may be spaced apart from each other in the first direction D1 with the semiconductor pattern SP interposed therebetween. The back gate structure BGS may extend in the second direction D2 between the semiconductor patterns SP adjacent to each other in the first direction D1. A plurality of back gate structures BGS may be provided. The back gate structures BGS may be disposed to be spaced apart from each other in the first direction D1.

When the back gate structure BGS is provided, the threshold voltage of the transistor including the semiconductor pattern SP may be adjusted by the voltage applied to the back gate structure BGS. Adjusting the threshold voltage through the back gate structure BGS may be easier than adjusting the threshold voltage by injecting impurities into the semiconductor pattern SP. By adjusting the threshold voltage through the back gate structure BGS, it may be possible to prevent the transistor from being unintentionally turned on.

The back gate structure BGS may include a back gate electrode BGE and a back gate insulating pattern BGI covering a side surface of the back gate electrode BGE. The back gate electrode BGE may be spaced apart from the gate electrode GE in the first direction D1 with the semiconductor pattern SP interposed therebetween. As an example, the back gate electrode BGE may include at least one of metal materials (e.g., Ti, Mo, W, Cu, Al, Ta, Ru, Ir, Co, etc.). In an implementation, the back gate insulating pattern BGI may include at least one of silicon oxide or a high-k dielectric material.

A first back gate capping pattern BGC1 may be provided on the upper surface of the back gate electrode BGE. The first back gate capping pattern BGC1 may be interposed between the back gate electrode BGE and the upper insulating layer UIL to be described later.

A second back gate capping pattern BGC2 may be interposed between the back gate electrode BGE and the lower insulating layer LIL. Each of the first back gate capping pattern BGC1 and the second back gate capping patterns BGC2 may include an insulating material. In an implementation, each of the first back gate capping pattern BGC1 and the second back gate capping patterns BGC2 may include silicon oxide.

A storage node contact BC may be provided on the semiconductor pattern SP. The storage node contact BC may be provided on an upper surface E1 of the semiconductor pattern SP. The storage node contact BC may include a conductive material. In an implementation, the storage node contact BC may include doped silicon. A plurality of storage node contacts BC may be provided. The storage node contacts BC may be disposed to be spaced apart from each other in the first direction D1 and the second direction D2.

The semiconductor pattern SP may be formed of a material that has etch selectivity relative to the gate insulating pattern GI and the back gate insulating pattern BGI. For instance, the semiconductor pattern SP be formed of a material that has etch selectivity relative to the gate insulating pattern GI and the back gate insulating pattern BGI, the first gate capping pattern GC1 and the first back gate capping pattern BCG1. Each of the gate insulating pattern GI and the back gate insulating pattern BGI and may be formed of a material that has etch selectivity relative to the semiconductor pattern SP, the first gate capping pattern GC1 and the first back gate capping pattern BCG1. The storage node contact BC may be formed of a material that has etch selectivity relative to the first gate capping pattern GC1, the first back gate capping pattern BGC1 and the back gate insulating pattern BGI.

Due to the process of forming the storage node contact BC through an engraving (e.g., etching) process described later, from a plan view, the shape of the storage node contact BC may follow the shape of the semiconductor pattern SP. As illustrated in the drawings, from a plan view, the semiconductor pattern SP may have a rectangular shape, but is not limited thereto. The cross-section of the storage node contact BC in a plan view may have the same shape as the cross-section of the semiconductor pattern SP, although the sizes of the respective cross-sections may differ (e.g., the cross-section of the storage node contact BC may be larger than that of the semiconductor pattern SP). For instance, the sidewall of the storage node contact BC may be consistently offset from the sidewall of the semiconductor pattern SP by a predefined distance.

A landing pad LP may be provided on the storage node contact BC. The landing pad LP may be connected to the semiconductor pattern SP through the storage node contact BC. The landing pad LP may include a conductive material. As an example, the landing pad LP may include at least one of doped semiconductor materials (e.g., doped silicon, doped germanium, etc.) or metal materials (e. g., Ti, Mo, W, Cu, Al, Ta, Ru, Ir, Co, etc.). A plurality of landing pads LP may be provided. The landing pads LP may be disposed to be spaced apart from each other in the first direction D1 and the second direction D2.

The storage node contact BC and the landing pad LP may together constitute a connection structure CNS.

A barrier pattern may be interposed between the storage node contact BC and the landing pad LP. As an example, the barrier pattern may include at least one of metal silicide materials (e.g., silicides of Ti, Mo, W, Cu, Al, Ta, Ru, Ir, Co, etc.) or a metal nitride (e.g., nitrides of Ti, Mo, W, Cu, Al, Ta, Ru, Ir, Co, etc.).

The upper insulating layer UIL may be provided on a side surface of each of the storage node contact BC and the landing pad LP. The upper insulating layer UIL may cover the side surface of each of the storage node contact BC and the landing pad LP. The upper insulating layer UIL may surround the side surface of each of the storage node contact BC and the landing pad LP. The upper insulating layer UIL may space apart the plurality of storage node contacts BC from each other. The upper insulating layer UIL may separate the plurality of landing pads LP from each other.

The upper insulating layer UIL may include an insulating material. In an implementation, the upper insulating layer UIL may include an insulating material different from each of the first gate capping pattern GC1 and the first back gate capping pattern BGC1. In an implementation, the upper insulating layer UIL may include an insulating material having a dielectric constant higher than that of each of the first gate capping pattern GC1 and the first back gate capping pattern BGC1. In an implementation, the upper insulating layer UIL may include SiN.

A data storage pattern DSP may be provided on the landing pad LP. The data storage pattern DSP may be connected to the semiconductor pattern SP through the landing pad LP and the storage node contact BC. A plurality of data storage patterns DSP may be provided. The data storage patterns DSP may be disposed to be spaced apart from each other in the first direction D1 and the second direction D2. The data storage pattern DSP may correspond to the data storage element DS described with reference to FIGS. 1 to 3.

The data storage pattern DSP may be, in an implementation, a capacitor including a lower electrode, a dielectric layer, and an upper electrode. In this case, the semiconductor device according to the disclosure may be a dynamic random access memory (DRAM). The data storage pattern DSP may include a magnetic tunnel junction pattern. In this case, the semiconductor device according to the disclosure may be a magnetic random access memory (MRAM). The data storage pattern DSP may further include a phase change material or a variable resistance material. In this case, the semiconductor device according to the disclosure may be a phase-change random access memory (PRAM) or a resistive random access memory (ReRAM). However, this is merely illustrative and the present disclosure is not limited thereto, and the data storage pattern DSP may include various structures and/or materials capable of storing data.

Referring to FIG. 6, various features of the configurations described below may be formed by the engraving process of the storage node contact BC. The features are described in detail below.

The upper surface E1 of the semiconductor pattern SP may have a concave profile. The upper surface E1 of the semiconductor pattern SP may have a profile concave that is concave into (e.g., recessed into) the semiconductor pattern SP.

The storage node contact BC may include a first region R1, and a second region R2 between the first region R1 and the semiconductor pattern SP. The first region R1 and the second region R2 may be distinguished at a first level LV1. The first level LV1 may be defined at a level of the upper surface of the semiconductor pattern SP. The first level LV1 may be defined at a level of the uppermost point of the semiconductor pattern SP (e.g., in the third direction D3). The first region R1 of the storage node contact BC is defined above the first level LV1 and the second region R2 of the storage nod contact BC is defined below the first level LV1.

The second region R2 of the storage node contact BC may be inserted into (e.g., extend into) and thus embedded within the semiconductor pattern SP. Since the upper surface E1 of the semiconductor pattern SP has a concave profile, a lower surface B2b of the second region R2 may have a convex profile. A lowermost surface of the second region R2 may be located at a vertical level lower than the first level LV1. In an implementation, the lower surface B2b of the second region R2 may be located at a lower vertical level than an upper surface GIa of the gate insulating pattern GI and an upper surface BGIa of the back gate insulating pattern BGI.

A portion of the semiconductor pattern SP may be interposed between the second region R2 of the storage node contact BC and the gate insulating pattern GI, and between the second region R2 and the back gate insulating pattern BGI. In an implementation, each of the gate insulating pattern GI and the back gate insulating pattern BGI may be in contact with a lower surface B1b of the first region R1 of the storage node contact BC.

At the first level LV1, with respect to the first direction D1, the first region R1 of the storage node contact BC may have a first width W1, and the second region R2 of the storage node contact BC may have a second width W2. With respect to the first direction D1, the semiconductor pattern SP may have a third width W3. The first width W1 may be greater than the second and third widths W2, W3. In one example, the second width W2 may be substantially equal to the third width W3.

The upper insulating layer UIL may be provided on an upper surface GCa of the first gate capping pattern GC1 and an upper surface of the first back gate capping pattern BGC1. Each of the upper surface GCa of the first gate capping pattern GC1 and the upper surface of the first back gate capping pattern BGC1 may have a concave profile. A lower surface Ub of the upper insulating layer UIL may have a convex profile. An upper surface Ua of the upper insulating layer UIL may be coplanar with an upper surface La of the landing pad LP.

Referring to FIG. 7, unlike the shape of the first region R1 of the storage node contact BC of FIG. 6, an upper surface B1a of the first region R1 of the storage node contact BC may have a concave profile. The upper surface B1a of the first region R1 may be concave into the first region R1. A lower surface Lb of the landing pad LP may have a convex profile.

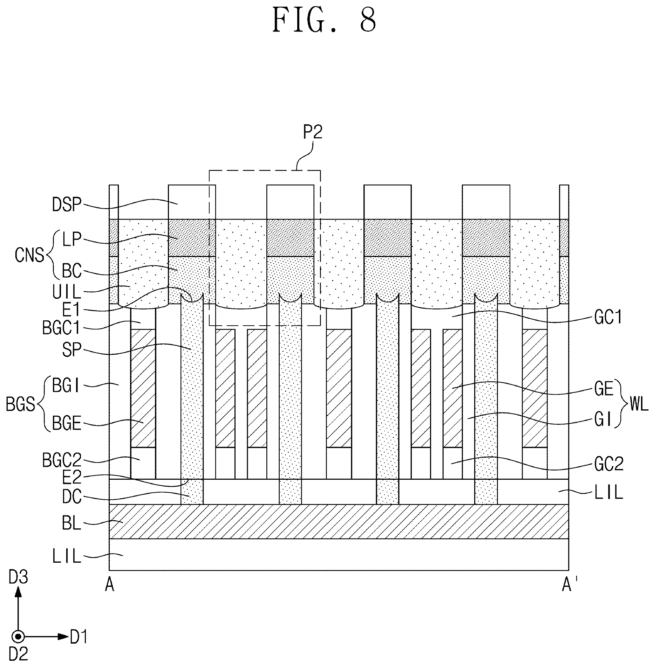

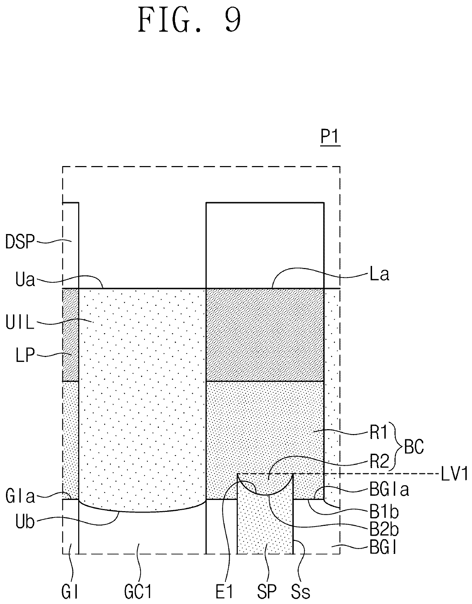

Hereinafter, a semiconductor device according to some implementations of the disclosure will be described with reference to FIGS. 8 and 9. For simplicity of description, description of content overlapping with the above-described content will be omitted, and differences from the above-described contents will be mainly described.

FIG. 8 is a cross-sectional view corresponding to line A-A' of FIG. 4. FIG. 9 is an enlarged view corresponding to P2 in FIG. 8.

Referring to FIGS. 4, 8, and 9, each of the upper surface GIa of the gate insulating pattern GI and the upper surface BGIa of the back gate insulating pattern BGI may be located at a vertical level lower than the first level LV1. The lower surface B1b of the first region R1 of the storage node contact BC may be located at a vertical level lower than the first level LV1. The semiconductor pattern SP may protrude into the storage node contact BC. A portion of the first region R1 of the storage node contact BC may cover a side surface Ss of an upper portion of the semiconductor pattern SP. As a result, a contact area between the storage node contact BC and the semiconductor pattern SP may be enlarged. Accordingly, electrical characteristics of the semiconductor device can be improved.

The upper portion of the semiconductor pattern SP may be interposed between the portion of the first region R1 of the storage node contact BC and the second region R2 of the storage node contact BC.

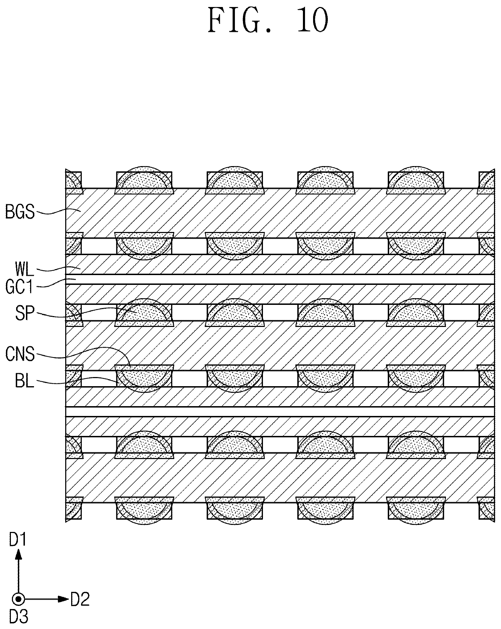

FIG. 10 is a plan view of a semiconductor device according to some implementations of the disclosure.

Referring to FIG. 10, the shape of the storage node contact BC may follow the shape of the semiconductor pattern SP from a plan view due to a process of forming the storage node contact BC through the engraving process to be described later. The cross-section of the storage node contact BC in a plan view may have the same shape as the cross-section of the storage semiconductor pattern SP, although the sizes of the respective cross-sections may differ (e.g., the cross-section of the storage node contact BC may be larger than that of the semiconductor pattern SP). As illustrated in the drawings, from a plan view, the semiconductor pattern SP may have a semi-elliptical shape. The storage node contact BC may also have a semi-elliptical shape.

Due to the process of forming the landing pad LP through the engraving process described below, from a plan view, the shape of the landing pad LP may follow (e.g., may be the same as) the shape of the storage node contact BC. As shown in the figure, from a plan view, the landing pad LP may have a semi-elliptical shape.

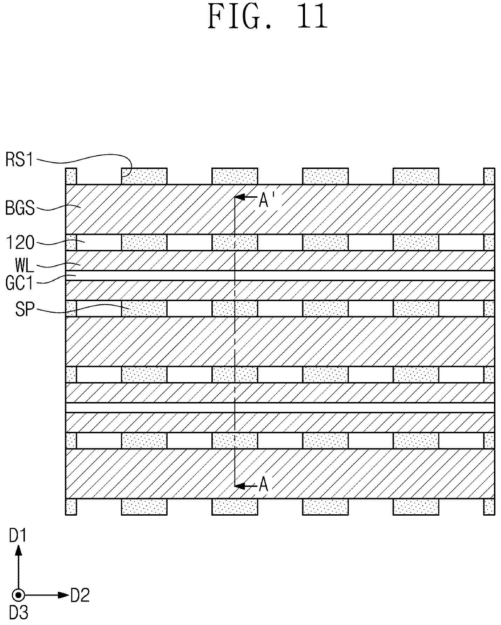

Hereinafter, a method of manufacturing a semiconductor device according to some implementations of the disclosure will be described with reference to FIGS. 11 to 18. For simplicity of description, description of content overlapping with the above-described content will be omitted, and differences from the above-described contents will be mainly described.

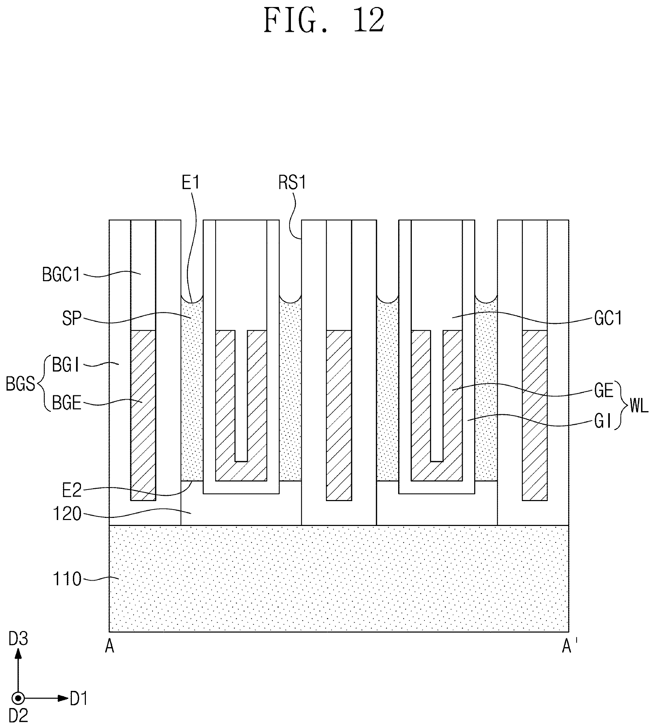

FIGS. 11 to 17 are diagrams illustrating a method of manufacturing a semiconductor device according to some implementations of the disclosure. FIGS. 11, 14, and 16 are cross-sectional views of the semiconductor device in accordance with some implementations of the disclosure. FIGS. 12, 13, 15, and 17 are cross-sectional views corresponding to lines A-A' of FIGS. 11, 14, and 16, respectively.

Referring to FIGS. 11 and 12, a first substrate 110 may be prepared. A dummy insulating layer 120 and a second substrate may be sequentially formed on the first substrate 110. In an example, the first substrate 110 and the second substrate may include a semiconductor material. The dummy insulating layer 120 may include an insulating material.

Then, a first patterning process may be performed on each of the dummy insulating layer 120 and the second substrate, and thus a first trench may be formed. The first patterning process may be performed on the second substrate, and thus a second trench may be formed. The back gate structure BGS and the first back gate capping pattern BGC1 may be formed in the first trench. The word line WL and the first gate capping pattern GC1 may be formed in the second trench.

Through the first and second patterning processes, the second substrate may be separated into semiconductor patterns SP extending in the second direction D2 and the third direction D3, respectively, and spaced apart from each other in the first direction D1. A third patterning process may be performed on the semiconductor pattern SP, so that the semiconductor pattern SP may be separated into semiconductor patterns SP spaced apart from each other in the second direction D2.

Thereafter, a removal (e.g., etching) process may be performed on an upper portion of each of the semiconductor patterns SP. First recesses RS1 may be formed on the upper surface E1 of each of the semiconductor patterns SP. The first recess RS1 may vertically overlap the semiconductor pattern SP. Each of a side surface of the gate insulating pattern GI and a side surface of the back gate insulating pattern BGI may be exposed by the first recess RS1. The first recesses RS1 may be formed by selectively etching the upper portion of each of the semiconductor patterns SP. The selective etching may be performed using an etchant that selectively etches the material of the semiconductor pattern SP (e.g., relative to the gate insulating pattern GI, the back gate insulating pattern BGI, the first gate capping pattern GCP1 and the first back gate capping pattern BGCP1). The upper surface E1 of each of the semiconductor patterns SP may be exposed by the first recess RS1 and may have a concave profile.

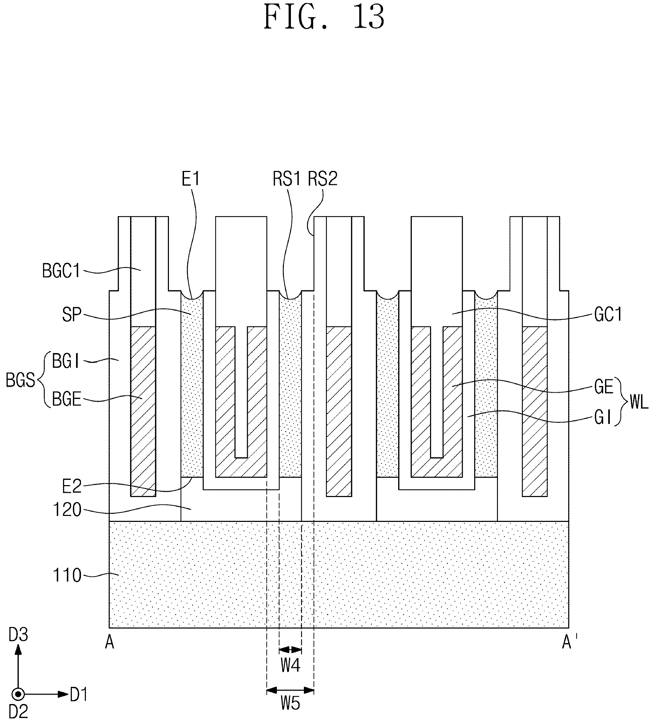

Referring to FIGS. 11 and 13, the second recess RS2 may be formed by removing (e.g., etching) a portion of each of the gate insulating pattern GI and the back gate insulating pattern BGI exposed by the first recess RS1. For example, an anisotropic etching process may be performed to widen the first recess RS1 to form the second recess RS2. More generally, an etching process may be performed that selectively etches the gate insulating pattern GI and the back gate insulating pattern BGI (e.g., relative to the semiconductor pattern SP). Accordingly, with respect to the first direction D1, a width W5 of the second recess RS2 may be larger than a width W4 of the first recess RS1. In other words, through the removal process for the inner wall of the first recess RS1, the width of the recess can be widened. In an implementation, the width W4 of the first recess RS1 may be substantially the same as the third width W3 described with reference to FIG. 6.

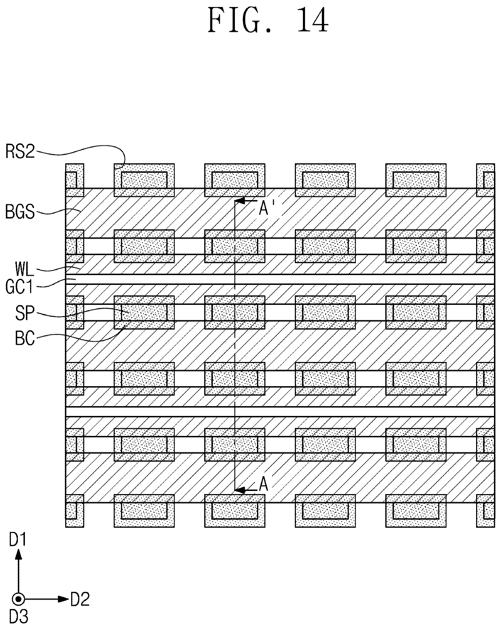

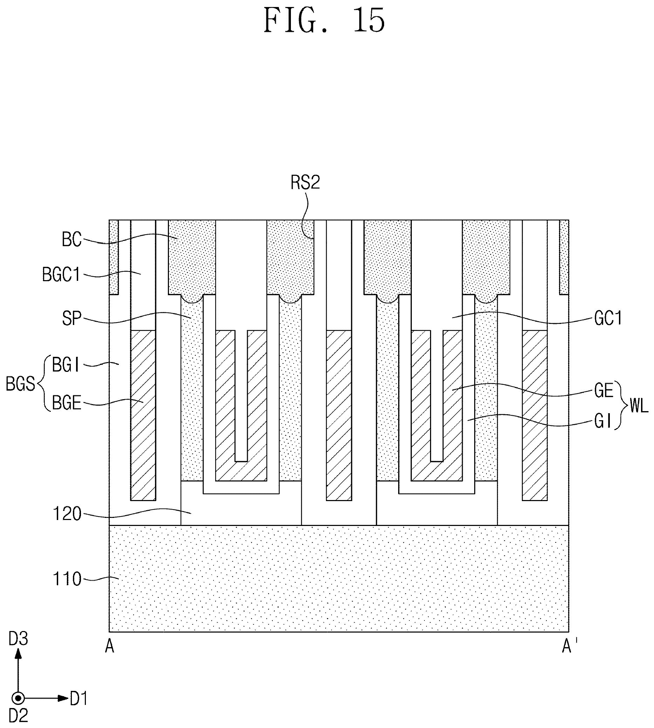

Referring to FIGS. 14 and 15, storage node contacts BC may be formed in the second recess RS2. In an implementation, forming the storage node contacts BC may include forming the storage node contacts BC by the engraving process. In an implementation, forming the storage node contacts BC may include forming a storage node contact layer filling an interior of the second recess RS2 and covering the upper surface of each of the first gate capping pattern GC1 and the first back gate capping pattern BGC1, and removing an upper portion of the storage node contact layer to separate the upper portion into the storage node contacts BC. For instance, the storage node contact layer may be etched back until the first gate capping pattern GC1, the first back gate capping pattern BGC1 and the back gate insulating pattern BGI are exposed.

According to the disclosure, the storage node contacts BC may be formed through the engraving process. The first recess RS1 may be formed through the removal process on the upper portion of the semiconductor pattern SP, and then the second recess RS2 may be formed through the removal process on the inner wall of the first recess RS1. As the second recess RS2 overlaps the semiconductor pattern SP, the storage node contact BC filling the second recess RS2 may be self-aligned with the semiconductor pattern SP. Accordingly, a miss-alignment between the storage node contact BC and the semiconductor pattern SP may be prevented. As a result, manufacturing process failure of the semiconductor device can be reduced. Accordingly, the productivity of the method for manufacturing the semiconductor device can be improved.

In addition, when forming the storage node contact BC through an alternative process (e.g., an embossing process), mask patterns may be required to form the storage node contact layer covering the upper surface of the first substrate 110 and to separate the storage node contact layer into the storage node contacts BC spaced apart from each other in the first direction D1 and the second direction D2. When forming the storage node contacts BC through the engraving process, the storage node contacts BC may be formed without the mask patterns. Accordingly, as the mask patterns are not used or the mask patterns are utilized in a formation process of another configuration, productivity of the method for manufacturing the semiconductor device can be improved.

In the present context, an engraving process may refer to a process of forming patterns within cavities and/or trenches formed within the semiconductor device. Accordingly, a shape of the patterns in an engraving process may be defined by the shape of the cavities and/or trenches that are formed within the semiconductor device itself. In contrast, an embossing process may be a process of forming patterns on one or more upper surfaces of the semiconductor device within one or more masks. Accordingly, a shape of the patterns in an embossing process may be defined by a shape of the one or more masks, which are subsequently removed.

In addition, due to the step of forming the second recess RS2, the width of the recess on the semiconductor pattern SP can be widened. Accordingly, the width of the storage node contact BC may be wider than when the second recess RS2 is not formed (that is, when only the first recess RS1 is formed). As a result, a contact area between the storage node contact BC and the landing pad (LP in FIG. 5) formed thereafter may be increased. Accordingly, electrical characteristics of the semiconductor device can be improved.

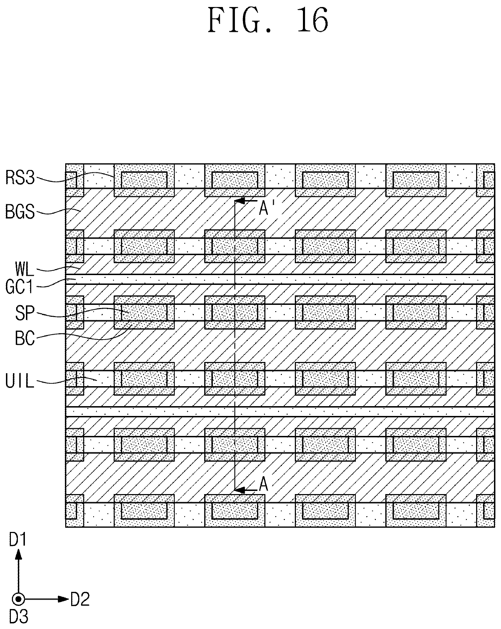

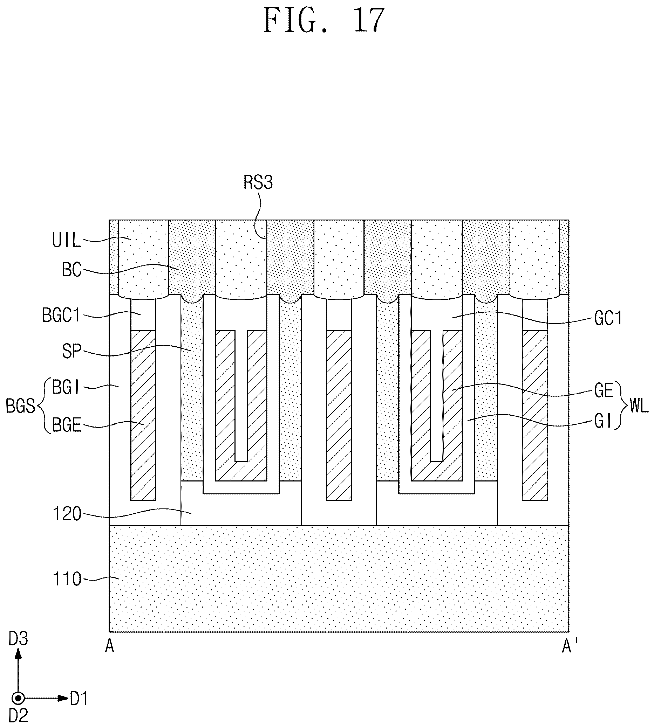

Referring to FIGS. 16 and 17, the upper insulating layer UIL may be formed between the storage node contacts BC through the engraving process. In an implementation, forming the upper insulating layer UIL may include removing (e.g., etching) each of a portion of the first gate capping pattern GC1 interposed between the storage node contacts BC, a portion of the first back gate capping pattern BGC1, and a portion of the back gate insulating pattern BGI to form a third recess RS3, and filling the upper insulating layer UIL in the third recess RS3. This may be achieved through selective etching of the upper portions of the first gate capping pattern GC1, the first back gate capping pattern BGC1, and the back gate insulating pattern BGI (e.g., relative to the storage node contacts BC). The side surfaces of the storage node contacts BC may be exposed by the third recess RS3. The upper surface of each of the first gate capping pattern GC1 and the first back gate capping pattern BGC1 may be exposed by the third recess RS3. When the upper insulating layer UIL is formed through the engraving process, the upper surface GCa (e.g., see FIG. 6) of the first gate capping pattern GC1 and the upper surface of the first back gate capping pattern BGC1 may each have a concave profile. Accordingly, the lower surface Ub (e.g., see FIG. 6) of the upper insulating layer UIL may have a convex profile.

Referring to FIGS. 4 and 5, after the formation process of the upper insulating layer UIL described with reference to FIGS. 16 and 17, the landing pads LP may be formed on the storage node contacts BC through the engraving process (e.g., etching process). In an implementation, forming the landing pads LP may include removing the upper portion of each of the storage node contacts BC, filling an area from which the upper portion of each of the storage node contacts BC has been removed, forming a landing pad layer covering the upper surface of the upper insulating layer UIL, and removing the upper portion of the landing pad layer to be separated into the landing pads LP. For instance, the upper portion of each storage node contact BC may be selectively etched (e.g., relative to the back gate insulating pattern BGI, the first gate capping pattern GC1 and the first back gate capping pattern BGC1). In an implementation, by removing the upper portion of each of the storage node contacts BC, the upper surface B1a (e.g., see FIG. 7) of each of the storage node contacts BC may have a concave profile, as described with reference to FIG. 7. In an implementation, the lower surface Lb (e.g., see FIG. 7) of each of the landing pads LP may have a convex profile.

In an implementation, the barrier patterns may be formed on the upper surfaces of the storage node contacts BC after the process of removing the upper portion of each of the storage node contacts BC and before the process of forming the landing pad layer. At this time, before the process of forming the barrier patterns, a cleaning process for the upper surfaces of each of the storage node contacts BC may be performed. Accordingly, Oxide unnecessarily formed on the upper surface of each of the storage node contacts BC may be removed.

According to the concept of the present disclosure, the upper insulating layer UIL including a nitride-based insulating material may replace insulating patterns interposed between the storage node contacts BC and including an oxide-based insulating material. Accordingly, it is possible to prevent the cleaning liquid from penetrating under the upper insulating layer UIL during the cleaning step. As a result, process failures caused by the cleaning liquid can be prevented, and the productivity of the manufacturing method of the semiconductor device can be improved.

According to the disclosure, the landing pad LP may be formed through the engraving process. The height of the landing pad LP may vary depending on the extent to which the storage node contact BC is removed. Accordingly, adjusting the height of the landing pad LP may be easier than forming the landing pad LP through the embossing process.

As an example, the barrier patterns may be formed on the storage node contacts BC prior to the formation process of the landing pads LP.

Then, the data storage pattern DSP may be formed on the connection structure CNS.

Thereafter, the top and bottom of the first substrate 110 (e.g., see FIG. 17) may be inverted. Accordingly, the lower surface of the first substrate 110 (e.g., see FIG. 17) may be exposed. The first substrate 110 (e.g., see FIG. 17) and the dummy insulating layer 120 (e.g., see FIG. 17) may be removed. At this time, a portion of the gate electrode GE (e.g., see FIG. 17) is removed, so that the gate electrode GE (e.g., see FIG. 17) may be separated into a pair of gate electrodes GE spaced apart from each other in the first direction D1. In an implementation, in this case, a portion of the semiconductor pattern SP may be removed. When the upper surface E1 of the semiconductor pattern SP described with reference to FIG. 12 is defined as a first surface and the lower surface E2 of the semiconductor pattern SP shown in FIG. 12 is define as a second surface, the second surface of the semiconductor pattern SP may be exposed through the removing process. The first surface of the semiconductor pattern SP may oppose (e.g., may be opposite) the second surface of the semiconductor pattern SP (e.g., in the third direction D3).

The second gate capping patterns GC2 may be formed to replace a portion of the gate electrodes GE, and the second back gate capping patterns BGC2 may be formed to replace a portion of the back gate electrodes BGE.

The bit line contact DC and the bit line BL may be sequentially formed on the second surface of the semiconductor pattern SP. The lower insulating layer LIL may be formed to cover the bit line contact DC and the bit line BL. The lower insulating layer LIL may be formed at various times regardless of before and after formation of the bit line contact DC and the bit line BL.

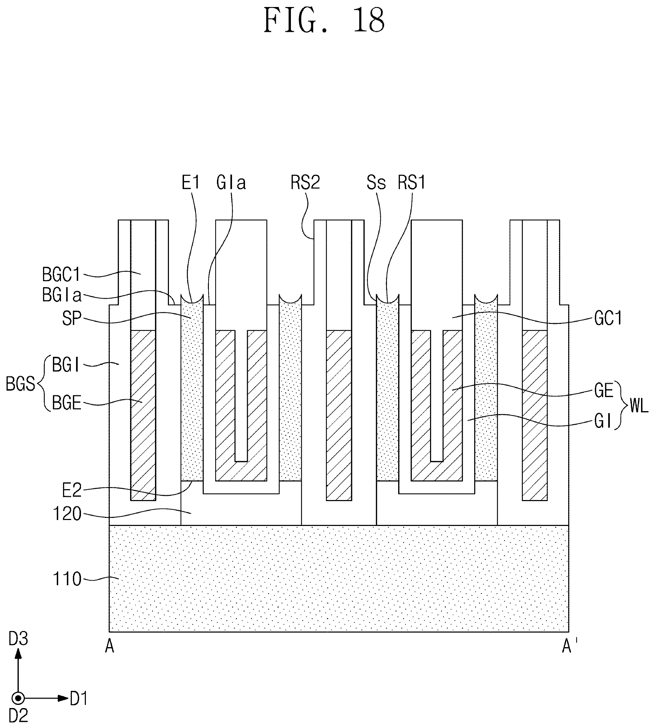

FIG. 18 is a diagram illustrating a method of manufacturing a semiconductor device according to some implementations of the disclosure. More specifically, FIG. 18 is a cross-sectional view corresponding to line A-A' of FIG. 11.

Referring to FIGS. 11 and 18, after the process of forming the second recess RS2 described with reference to FIG. 13, unlike that shown in FIG. 13, the lower surface in the second recess RS2 may be formed to be located at a lower vertical level than the uppermost surface of the semiconductor pattern SP. For instance, the second recess RS2 may be formed to a greater depth than the first recess RS1. Accordingly, a portion of the upper side surface Ss of the semiconductor pattern SP may be exposed by the second recess RS2. The second recess RS2 may be formed such that the upper surface GIa of the gate insulating pattern GI is located at a lower vertical level than the uppermost surface of the semiconductor pattern SP. By the second recess RS2, the upper surface BGIa of a portion of the back gate insulating pattern BGI may be formed to be located at a lower vertical level than the uppermost surface of the semiconductor pattern SP.

Then, the semiconductor device described with reference to FIGS. 4, 8, and 9 can be manufactured through the method for manufacturing the semiconductor device described above.

According to the disclosure, the storage node contact may be formed by the engraving process that fills the region where the upper portion of the semiconductor pattern has been removed. Accordingly, the storage node contact may be self-aligned with the semiconductor pattern. As a result, miss-alignment between the storage node contact and the semiconductor pattern may be prevented. As a result, manufacturing process failure of the semiconductor device can be reduced. Accordingly, the productivity of the method for manufacturing the semiconductor device can be improved.

In addition, by forming the storage node contact through the engraving process, the mask patterns required when forming the storage node contact through the embossing process may not be used, or may be utilized in the formation process of another configuration. As a result, the productivity of the method for manufacturing the semiconductor device can be improved.

According to the concept of the present disclosure, the upper insulating layer including a nitride-based insulating material can replace insulating patterns interposed between storage node contacts and including an oxide-based insulating material. Accordingly, in the cleaning process on the upper surface of the storage node contact for forming the barrier pattern, it is possible to prevent the cleaning liquid from penetrating under the upper insulating layer. As a result, process failures caused by the cleaning liquid can be prevented, and the productivity of the manufacturing method of the semiconductor device can be improved.

According to the disclosure, the landing pad may be formed by the engraving process that fills the area where the upper portion of the storage node contact has been removed. The height of the landing pad may vary depending on the extent to which the storage node contact is removed. Thus, adjusting the height of the landing pad may be easier than forming the landing pad through the embossing process.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While implementations are described above, a person skilled in the art may understand that many modifications and variations are made without departing from the scope of the disclosure defined in the following claims. Accordingly, the example implementations of the disclosure should be considered in all respects as illustrative and not restrictive, with the scope of the disclosure being indicated by the appended claims.

In addition to the implementations described above, the following implementations are also innovative:
Implementation 1 is a method for manufacturing a semiconductor device. The method includes: forming a semiconductor pattern on a first substrate, the semiconductor pattern extending in a direction perpendicular to the first substrate; forming a gate insulating pattern and a gate electrode in turn on a side surface of the semiconductor pattern; forming a capping pattern on the gate electrode; removing an upper portion of the semiconductor pattern to form a first recess exposing a side surface of the gate insulating pattern; removing a portion of the gate insulating pattern exposed by the first recess to form a second recess; forming a storage node contact in the second recess; removing a portion of the capping pattern to form a third recess exposing a side of the storage node contact; and forming an upper insulating layer in the third recess.
Implementation 2 is the method of implementation 1, wherein the method further includes: removing an upper portion of the storage node contact; and forming a landing pad in a region where the upper portion of the storing node contact is removed.
Implementation 3 is the method of implementation 1 or implementation 2, wherein after the process of removing the upper portion of the storage node contact, the upper surface of the storage node contact may have a concave profile.
Implementation 4 is the method of any of implementations 1-3, wherein with respect to the first direction, a width of the second recess may be greater than a width of the first recess.
Implementation 5 is the method of any of implementations 1-4, wherein after the process of forming the first recess, the upper surface of the semiconductor pattern may have a concave profile.
Implementation 6 is the method of any of implementations 1-5, wherein after the process of forming the third recess, the upper surface of the capping pattern may have a concave profile.
Implementation 7 is the method of any of implementations 1-6, wherein the upper insulating layer may include an insulating material different from the capping pattern.
Implementation 8 is the method of any of implementations 1-7, wherein a portion of the side surface of the semiconductor pattern may be exposed by the second recess.
Implementation 9 is the method of any of implementations 1-8, wherein a first surface of the semiconductor pattern may be exposed by the first recess, and the method for manufacturing a semiconductor device may further include: flipping the first substrate, and then removing the first substrate to expose a second surface of the semiconductor patterns, the second surface of the semiconductor pattern opposes the first surface of the semiconductor pattern; and forming a bit line on the second surface of the semiconductor pattern.
Implementation 10 is the method of any of implementations 1-9, wherein the method may further include forming a back gate electrode spaced apart from the gate electrode with the semiconductor pattern interposed therebetween.

Further implementations are set out in the following Clauses:
Clause 1. A semiconductor device, comprising:
   a bit line on a substrate and extending in a first direction parallel to an upper surface of the substrate;
   a semiconductor pattern on the bit line and extending in a direction perpendicular to the upper surface of the substrate;
   a gate electrode on a side surface of the semiconductor pattern and extending in a second direction intersecting the first direction;
   a storage node contact on an upper surface of the semiconductor pattern;
   an upper insulating layer covering a side surface of the storage node contact; and
   a capping pattern between the upper insulating layer and the gate electrode,
   wherein the upper insulating layer is on an upper surface of the capping pattern,
   wherein the storage node contact comprises a first region and a second region between the first region and the semiconductor pattern, and
   wherein the upper surface of the capping pattern has a concave profile and a lower surface of the second region of the storage node contact has a convex profile.
Clause 2. The semiconductor device of Clause 1, wherein the second region of the storage node contact is embedded within the semiconductor pattern.
Clause 3. The semiconductor device of Clause 1 or Clause 2, wherein the first region of the storage node contact is defined above a first level and the second region of the storage nod contact is defined below the first level, and
   wherein, with respect to the first direction, a width of the second region of the storage node contact defined with reference to the first level is less than a width of the first region of the storage node contact defined with reference to the first level, and is equal to a width of the semiconductor pattern.
Clause 4. The semiconductor device of any of Clauses 1-3, comprising a gate insulating pattern between the semiconductor pattern and the gate electrode, and
   wherein a portion of the semiconductor pattern is interposed between the second region of the storage node contact and the gate insulating pattern.
Clause 5. The semiconductor device of any of Clauses 1-4, wherein a lowermost surface of the second region of the storage node contact is located lower than an uppermost surface of the semiconductor pattern.
Clause 6. The semiconductor device of any of Clauses 1-5, wherein the upper insulating layer and the capping pattern include different insulating materials, and
   wherein a lower surface of the upper insulating layer has a convex profile.
Clause 7. A semiconductor device, comprising:
   a bit line on a substrate and extending in a first direction parallel to an upper surface of the substrate;
   a semiconductor pattern on the bit line and extending in a direction perpendicular to the upper surface of the substrate;
   a gate electrode on a side surface of the semiconductor pattern and extending in a second direction intersecting the first direction;
   a back gate electrode spaced apart from the gate electrode in the first direction and extending in the second direction with the semiconductor pattern interposed therebetween;
   a storage node contact on an upper surface of the semiconductor pattern;
   a landing pad on the storage node contact;
   a data storage pattern on the landing pad;
   an upper insulating layer covering a side surface of the storage node contact; and
   a capping pattern between the upper insulating layer and the gate electrode,
   wherein the upper insulating layer is on an upper surface of the capping pattern, and
   wherein the upper surface of the semiconductor pattern and the upper surface of the capping pattern each have a concave profile.

## Claims

1. A semiconductor device, comprising:
a bit line (BL) on a substrate (100, 200) and extending in a first direction parallel to an upper surface of the substrate (100, 200);
a semiconductor pattern (SP) on the bit line (BL) and extending in a direction perpendicular to the upper surface of the substrate (100, 200);
a gate electrode (GE) on a side surface of the semiconductor pattern (SP) and extending in a second direction intersecting the first direction;
a storage node contact (BC) on an upper surface of the semiconductor pattern (SP);
an upper insulating layer (UIL) covering a side surface of the storage node contact (BC); and
a capping pattern (BGC1) between the upper insulating layer (UIL) and the gate electrode (GE),
wherein the upper insulating layer (UIL) is on an upper surface of the capping pattern (BGC1), and
wherein the upper surface of the semiconductor pattern (SP) and the upper surface of the capping pattern (BGC1) each have a concave profile.

2. The semiconductor device of claim 1, wherein the storage node contact (BC) comprises a first region (R1) and a second region (R2) between the first region (R1) and the semiconductor pattern (SP), and
wherein a lower surface of the second region (R2) of the storage node contact (BC) has a convex profile.

3. The semiconductor device of claim 2, comprising a gate insulating pattern (GI) between the semiconductor pattern (SP) and the gate electrode (GE), and
wherein the lower surface of the second region (R2) of the storage node contact (BC) is located lower than an upper surface of the gate insulating pattern (GI).

4. The semiconductor device of claim 2 or claim 3, wherein an upper surface of the first region (R1) of the storage node contact (BC) has a concave profile.

5. The semiconductor device of any of claims 2-4, wherein a portion of the first region (R1) of the storage node contact (BC) covers a side surface of an upper portion of the semiconductor pattern (SP).

6. The semiconductor device of any of claims 2-5, wherein a lower surface of the first region (R1) of the storage node contact (BC) is located lower than an uppermost surface of the semiconductor pattern (SP).

7. The semiconductor device of claim 1, wherein the storage node contact (BC) comprises a first region (R1), and a second region (R2) between the first region (R1) and the semiconductor pattern (SP),
wherein the second region (R2) of the storage node contact (BC) is inserted into the semiconductor pattern (SP).

8. The semiconductor device of claim 1, wherein the storage node contact (BC) comprises a first region (R1) and a second region (R2) between the first region (R1) and the semiconductor pattern (SP),
wherein the first region (R1) of the storage node contact (BC) is defined above a first level, and the second region (R2) of the storage nod contact is defined below the first level, and
wherein, with respect to the first direction, a width of the first region (R1) of the storage node contact (BC) defined with reference to the first level is greater than a width of the second region (R2) of the storage node contact (BC) defined with reference to the first level.

9. The semiconductor device of claim 8, wherein with respect to the first direction, the width of the second region (R2) of the storage node contact (BC) defined with reference to the first level is equal to the width of the semiconductor pattern (SP).

10. The semiconductor device of any preceding claim, wherein the upper insulating layer (UIL) and the capping pattern (GC1) include different insulating materials.

11. The semiconductor device of any preceding claim, wherein a lower surface of the upper insulating layer (UIL) has a convex profile.

12. The semiconductor device of any preceding claim, wherein each of the semiconductor pattern (SP) and the storage node contact (BC) has a semi-elliptical shape.

13. The semiconductor device of any preceding claim, wherein the semiconductor pattern (SP) is a first semiconductor pattern, and
wherein the semiconductor device comprises:
a second semiconductor pattern and a third semiconductor pattern spaced apart from each other in the first direction with the first semiconductor pattern interposed between the second semiconductor pattern and the third semiconductor pattern; and
a back gate electrode (BGE) between the first semiconductor pattern and the second semiconductor pattern, and
wherein the gate electrode (GE) includes a pair of gate electrodes spaced apart from each other in the first direction between the first semiconductor pattern and the third semiconductor pattern.
